Europäisches Patentamt

European Patent Office

Office européen des brevets

(11) Veröffentlichungsnummer: **0 022 934**

**A1**

(19)

(12) **EUROPÄISCHE PATENTANMELDUNG**

(21) Anmeldenummer: **80103432.3**

(22) Anmeldetag: **19.06.80**

(51) Int. Cl.³: **G 02 F 1/133**

(30) Priorität: **18.07.79 DE 7920579 U**

(43) Veröffentlichungstag der Anmeldung:
**28.01.81 Patentblatt 81/4**

(84) Benannte Vertragsstaaten:
**CH FR GB IT LI NL**

(71) Anmelder: **SIEMENS AKTIENGESELLSCHAFT Berlin
und München**
**Postfach 22 02 61**
**D-8000 München 22(DE)**

(72) Erfinder: **Karzmarzyk, Manfred, Dipl.-Ing.**
**Münchnerstrasse 61**
**D-8150 Holzkirchen(DE)**

(72) Erfinder: **Slowioczek, Augustin, Ing.-grad.**
**Edelweisstrasse 140**
**D-8021 Taufkirchen(DE)**

(54) Elektrooptische Anzeigevorrichtung, insb. Flüssigkristallanzeige.

(57) Elektrooptische Anzeigevorrichtung, insbesondere Flüssigkristallanzeige, bei der das eigentliche Display (1) mit der zugehörigen Ansteuereinheit über eine klemmend eingebrachte, elastische Kontaktbrücke elektrisch verbunden ist.

Es wird vorgeschlagen, daß die Kontaktbrücke aus einer biegsamen Folie (3) mit aufgedampften Leiterbahnen (18) besteht. Die Leiterbahnkonfiguration läßt sich durch elektrisches HF-Ausbrennen und/oder Abdeckungen bei der Bedampfung der Folie (3) erzeugen. Die Folie (3) ruht normalerweise auf elastischen, als Wiederlager fungierenden Körpern; sie kann aber auch selbsthaltend eingeklemmt werden.

Die Neuerung findet vor allem dann Verwendung, wenn das Display (1) gegenüber dem Ansteuerbaustein (2) eine Lage einnehmen muß, bei der die im Handel erhältlichen standardisierten Verbinder (Steckerleisten, Zebrastreifen) nicht zu gebrauchen sind.

FIG. 1

EP 0 022 934 A1

SIEMENS AKTIENGESELLSCHAFT          Unser Zeichen
Berlin und München                  VPA 79 P 1122 EUR

Elektrooptische Anzeigevorrichtung, insb. Flüssigkristallanzeige

Die Erfindung betrifft eine Anzeigevorrichtung gemäß
dem Oberbegriff des Anspruchs 1. Ein solches Display ist beispielsweise aus "Electronics", 07.07.77,
Seiten 96 bis 103, bekannt.

Wenn der elektrische Kontakt zwischen der eigentlichen Anzeigezelle und der zugehörigen Ansteuereinheit lösbar gestaltet sein soll, so bietet es
sich an, beide Teile durch eine Steckerleiste miteinander zu verbinden. Stecker schaffen einen recht
sicheren Kontakt, sind jedoch relativ kompliziert
aufgebaut, haben zudem eine sperrige Bauform und
kommen häufig schon deshalb nicht in Frage, weil

Les 1 Ode /12.07.79

sie nur ganz bestimmte Lagen zwischen den zu kontaktierenden Teilen zulassen. Man zieht daher in vielen Fällen elastische "Zebra"-Streifen vor, die, wie in der zitierten Veröffentlichung beschrieben, abwechselnd aus leitenden und isolierenden Abschnitten bestehen und einfach zwischen die zu verbindenden Bauteile geklemmt werden. Solche Leitgummis liefern ebenfalls einen zufriedenstellenden Kontakt, sind dabei recht kompakt und einfach ausgeführt, lassen aber nach wie vor nur einen geringen Spielraum bei der Wahl der Kontaktanordnung zu. Dementsprechend ist man nicht selten auf Sonderfertigen angewiesen, ein Umstand, der vor allem bei preiswerten Massenartikeln zu denen inzwischen auch Flüssigkristallanzeigen gehören, nicht akzeptiert werden kann.

Es fehlt demnach noch immer an einem elektrischen Verbinder, der kostengünstig hergestellt werden kann, dabei eine zuverlässige Kontaktierung gewährleistet und zudem eine in weiten Grenzen frei wählbare Kontaktgeometrie zuläßt. Um diese Lücke zu schließen, wird erfindungsgemäß ein Display mit den Merkmalen des Patentanspruchs 1 vorgeschlagen.

Die Kontaktfolie einer erfindungsgemäßen Anzeigevorrichtung läßt die verschiedensten Relativlagen zwischen Zelle und Platine zu, da sie biegsam ist und sogar geknickt werden kann, ohne daß man eine Kontaktverschlechterung befürchten müßte. Darüber hinaus gibt die Folienfertigung keinerlei Probleme auf, denn man kann beliebige Leiterbahnkonfigurationen ohne weiteres durch elektrisches HF-Ausbrennen und/oder Abdecken bei der Folienbedampfung erzeugen. So bereitet es auch keinerlei Schwierigkeiten, Kontaktleisten mit voneinander differierenden Kontaktabständen miteinander zu verbinden. Besonders feine Leiterstrukturen, wie sie beispielsweise für den Anschluß von Flüssigkristalldisplays erforderlich sind, lassen sich durch einen HF-Ausbrenn-Prozeß herausarbeiten, bei dem die Brennstelle durch einen Rechner-gesteuerten Digital-Plotter geführt wird. Im übrigen kann man auf die gleichen Techniken zurückgreifen, mit denen bereits Heizfolien auf Kapton-Basis erzeugt werden (vergl. hierzu in der eingangs erwähnten Literaturstelle den Abschnitt LCD-Heaters). Die Kontaktfolien sind auch in großen Abmessungen bequem herstellbar und können aus thermisch angepaßten Werkstoffen bestehen, so daß die Kontaktgabe auch unter erhöhten Betriebstemperaturen an keiner Stelle gefährdet ist.

In der Regel wird die Kontaktfolie durch einen elastischen Körper, der keine elektrische Funktion erfüllt und ein einfaches Gummiteil sein kann, an die Display- bzw. Steuerteilplatte gedrückt. Unter bestimmten Umständen - wenn etwa die Anzeigevorrichtung keinen mechanischen Erschütterungen ausgesetzt ist - könnte man auf solche Wiederlager auch verzichten.

Weitere vorteilhafte Ausgestaltungen und Weiterbildungen der Erfindung sind Gegenstand zusätzlicher Ansprüche.

Der Lösungsvorschlag soll nun anhand von vier bevorzugten Ausführungsbeispielen in Verbindung mit der beigefügten Zeichnung näher erläutert werden. In den Figuren sind einander entsprechende Teile mit gleichen Bezugszeichen versehen. Es zeigen:

Fig. 1 ein erstes Ausführungsbeispiel in einem Seitenschnitt

Fig. 2 in einem teilweise weggebrochenen Seitenschnitt ein zweites Ausführungsbeispiel und

Fig. 3 und 4 in der gleichen Darstellungsweise wie bei Fig. 1 weitere Ausführungsbeispiele.

Die Figuren sind der Übersicht halber sehr schematisch gehalten. So fehlen beispielsweise Halterungs- und Klemmelemente oder einzelne Zuleitungen, also Einzelteile, die für ein Verständnis der Erfindung nicht unbedingt erforderlich sind.

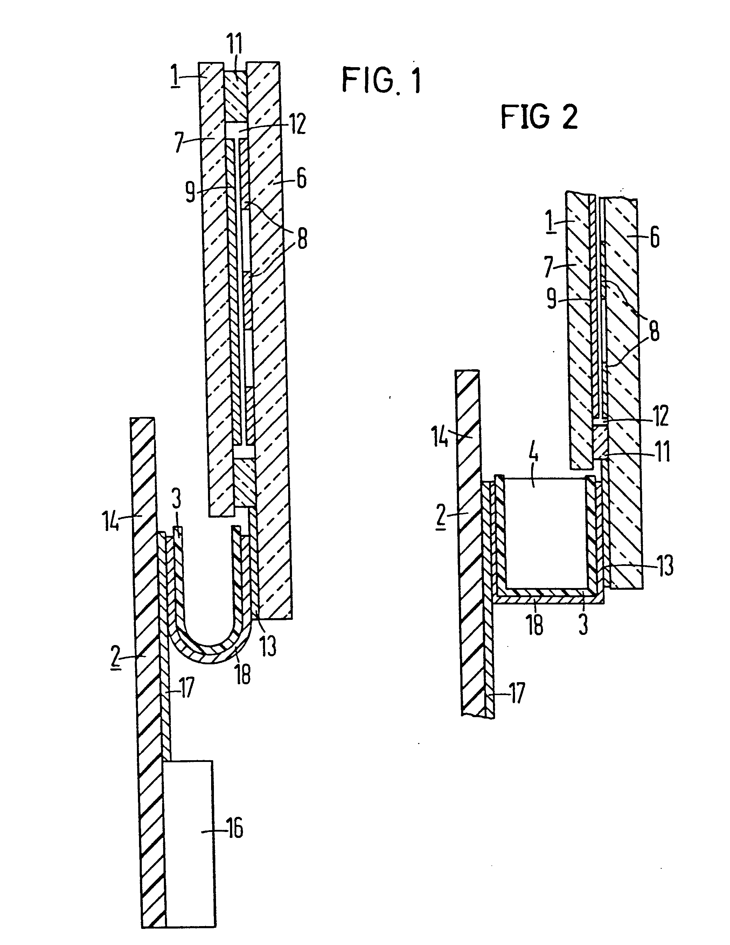

Die Fig. 1 zeigt eine Flüssigkristall-Anzeigevorrichtung mit einer Anzeigezelle 1, einer Ansteuereinheit 2 und einer Kontaktfolie 3. Die Anzeigezelle enthält zwei zueinander parallele Platten 6,7, die auf ihren einander zugewandten Seiten jeweils elektrisch leitende Beläge (getrennt ansteuerbare Vorderelektroden 8, Rückelektrode 9) tragen und über einen Rahmen 11 dicht miteinander verbunden sind. Die vom Rahmen und den beiden Platten begrenzte Kammer ist mit einer Flüssigkristallschicht 12 gefüllt. Die Zuleitungen zu den einzelnen Elektroden (Elektrodenzuleitungen 13) nehmen ihren Anfang in Kontaktstellen, die in üblicher Weise auf dem Innenseitenrand einer der beiden Platten äquidistant nebeneinanderliegen. Die Ansteuereinheit 2 umfaßt eine Platine 14, auf der eine integrierte Schaltung 16 befestigt ist. Von dieser Schaltung gehen Verbindungsleitungen 17 aus, die ebenfalls in einer Reihe aus nebeneinanderliegenden Kontaktstellen münden. Zwischen beide Kontaktleisten ist die mit Leiterbahnen 18 versehene, u-förmig gebogene Kontaktfolie 3 eingeklemmt. Die Folie nimmt dabei eine Position ein, in der ihre Leiterbahnen den jeweiligen Kontaktstellen anliegen.

Das Ausführungsbeispiel der Fig. 2 unterscheidet sich von der geschilderten Ausführung im wesentlichen darin, daß die u-förmig gebogene Kontaktfolie ein Andruckgummi 4 mit rechteckigem Pofil an drei Seiten umschließt. Das elastische Wiederlager trägt dazu bei, daß der Kontakt besonders robust und zuverlässig ist.

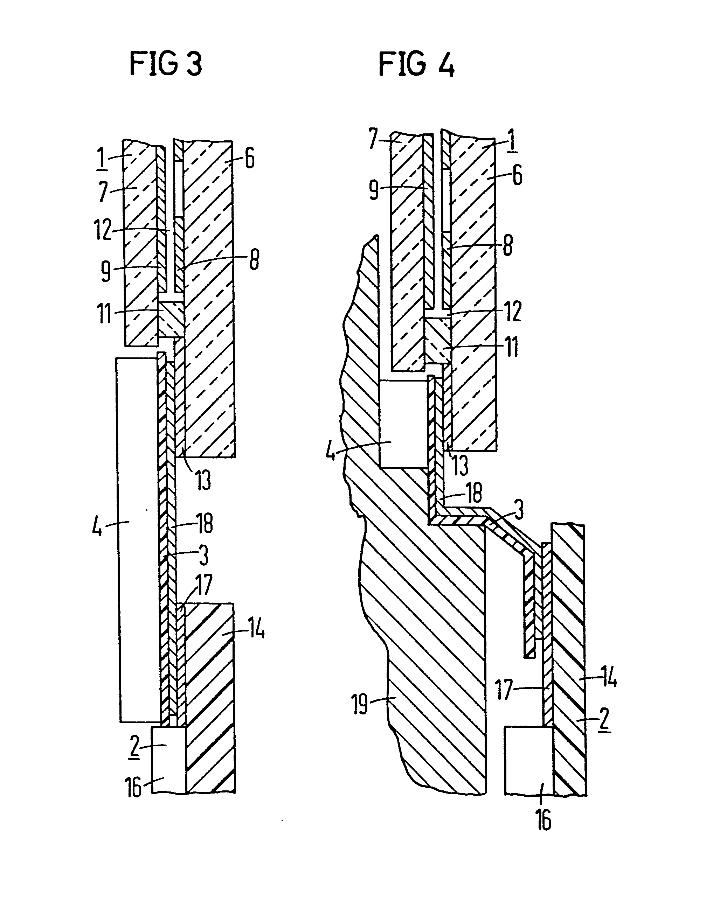

Die in den Figuren 3 und 4 dargestellten Anzeigeversionen sind Beispiele dafür, daß die gleiche Folie die verschiedensten räumlichen Zuordnungen zwischen Zelle und Platine gestattet. Bei der Variante der Fig. 3 befinden sich die Kontaktleisten beider Teile in der gleichen Ebene, jedoch auf verschiedenen Höhen; in Fig. 4 ist gezeigt, daß die Kontaktleisten sowohl in unterschiedlichen Höhen als auch in zueinander versetzten Ebenen liegen können. Die Folie läßt sich dabei auch entlang eines Wandungsteils oder längs der Grenzfläche eines nicht zugänglichen Raumes führen (dieser Raum ist in Fig. 4 schraffiert eingezeichnet und mit 19 bezeichnet)

Die Kontaktfolie kann folgendermaßen hergestellt werden:
Auf ein Kapton-Substrat wird eine Metallschicht aufgedampft, aus der dann einzelne Leiterbahnen mit definierten Pfaden, Abständen und Breiten herausgebrannt werden. Hierzu führt man mit einem Tischrechner-gesteuerten Digital-Plotter eine Nadel, die einen definierten Durchmesser hat und die benötigte Ausbrennenergie durch einen angeschlossenen HF-Generator erhält.

Die Erfindung ist nicht auf die dargestellten Ausführungsbeispiele beschränkt. So kommen neben Flüssigkristallanzeigen auch andere Displaytypen infrage, die bereichsweise zwischen optisch verschiedenen Zuständen geschaltet werden können und dementsprechend über mehrere Anschlüsse verfügen. Dabei spielt es keine Rolle, ob die Anzeige statisch oder in einem Zeitmultiplexverfahren angesteuert wird. Auch in konstruktiver Hinsicht besteht noch ein erheblicher Spielraum. So kann das Display auch mit mehreren Kontaktleisten versehen sein, die dann jeweils mit einer Folie an den Ansteuermodul anzuschließen sind. Die Vorzüge des Lösungsvorschlags kommen vor allem dann zum Tragen, wenn die miteinander zu kontaktierenden Platten zueinander geneigt sind.

3 Schutzansprüche

4 Figuren

Patentansprüche

1. Elektrooptische Anzeigevorrichtung, insb. Flüssigkristallanzeige, enthaltend

A) eine Anzeigezelle mit einer Platte (Trägerplatte),
auf der elektrische Zuleitungen in einer Reihe
aus nebeneinanderliegenden Kontaktstellen (Kontaktleiste) enden,

B) einen Ansteuerbaustein mit einer Platte (Platine),
auf der Ausgangsleitungen ebenfalls in einer Kontaktleiste enden,

C) einen elastischen, den beiden Platten angedrückten
Körper mit einer Vielzahl von gegeneinander isolierten elektrischen Leitern, die die Kontaktstellen der
Trägerplatte jeweils mit einer Kontaktstelle der
Platine elektrisch verbinden,

d a d u r c h    g e k e n n z e i c h n e t , daß

D) der elastische Körper eine biegsame Folie ist
und daß

E) die Leiter der Folie aufmetallisiert sind.


2. Anzeigevorrichtung nach Anspruch 1, d a d u r c h
g e k e n n z e i c h n e t , daß die Platten die
Folie jeweils gegen einen elastischen Körper drücken.


3. Anzeigevorrichtung nach Anspruch 1 oder 2,
d a d u r c h    g e k e n n z e i c h n e t , daß
dann, wenn die beiden Kontaktleisten auf etwa gleicher
Höhe einander gegenüberliegen, die zwischen den beiden
Platten befindliche Folie u-förmig gebogen ist und
ggf. einen einzigen elastischen Körper umgibt.

FIG. 1

FIG 2

FIG 3

FIG 4

## EINSCHLÄGIGE DOKUMENTE

| Kategorie | Kennzeichnung des Dokuments mit Angabe, soweit erforderlich, der maßgeblichen Teile | betrifft Anspruch |
|---|---|---|
| X | US - A - 3 718 842 (C.P. ABBOTT III et al.) *Spalte 2, Zeilen 45 bis 63; Fig. 3 * -- | 1-3 |
| | DE - A1 - 2 427 335 (SHARP K.K.) * Ansprüche 1 und 2 * -- | 1 |
| A | SOLID-STATE TECHNOLOGY, Vol. 22, No. 1, January 1979 Washington J. MARSHALL et al. " Solder Bump Interconnected, Multiple Chip, Thick Film Hybrid for 40-Character Alphanumeric LCD Application" Seiten 87 bis 93 ---- | |

**KLASSIFIKATION DER ANMELDUNG (Int.Cl.)**

G 02 F 1/133

**RECHERCHIERTE SACHGEBIETE (Int. Cl.)**

G 02 F 1/133
G 06 F 15/02
G 09 F 9/00

**KATEGORIE DER GENANNTEN DOKUMENTE**

X: von besonderer Bedeutung

A: technologischer Hintergrund

O: nichtschriftliche Offenbarung

P: Zwischenliteratur

T: der Erfindung zugrunde liegende Theorien oder Grundsätze

E: kollidierende Anmeldung

D: in der Anmeldung angeführtes Dokument

L: aus andern Gründen angeführtes Dokument

&: Mitglied der gleichen Patentfamilie, übereinstimmendes Dokument

X Der vorliegende Recherchenbericht wurde für alle Patentansprüche erstellt.

| Recherchenort | Abschlußdatum der Recherche | Prüfer |
|---|---|---|
| Berlin | 25-09-1980 | FUCHS |

EPA form 1503.1   06.78